# EUROPEAN PATENT APPLICATION

(11) **EP 0 583 784 A2**
(43) Date of publication of application: **23.02.1994**
(21) Application number: 93113267.4
(22) Date of filing: 19.08.1993
(51) Int. Cl.: G03F 7/16, G03F 7/09, H01L 21/00, H01L 21/3105

(54) **Apparatus and method for interlevel dielectric planarization**

(71) Applicant: TEXAS INSTRUMENTS INCORPORATED, Dallas Texas 75265 (US)
(72) Inventor: Tigelaar, Howard L., Allen, TX 75002 (US)
(74) Representative: Schwepfinger, Karl-Heinz, Dipl.-Ing.

(57) **Abstract**

A flowable dielectric material is applied to the processing side of wafers (24-31), and then the wafers (24-31) are arranged in a centrifuge-like apparatus (10) with the processing side facing its center axis (34). The centrifuge-like apparatus (10) then spins to generate a centrifugal force directed perpendicularly into the processing side of the wafers (24-31). The flowable dielectric material is thus spread evenly across the wafer surfaces.

## Description

### TECHNICAL FIELD OF THE INVENTION

This invention relates in general to the field of VLSI semiconductor device processing, and more particularly the present invention relates to apparatus and a method for interlevel dielectric planarization.

### BACKGROUND OF THE INVENTION

Planarization has become an important semiconductor processing step as circuit dimensions reached submicron scales, and multiple level metallization became the norm. The planarization step is necessary because the lenses used to project images of the submicron circuit patterns have limited depth of focus and cannot focus sharply on a wafer surface with height variations.

Conventional planarization methods include reflowing the oxide layer, which smoothes the wafer surface. With today's smaller circuit geometries, the result of using this method alone is unsatisfactory. Another method polishes or grinds the wafer surfaces to achieve a smooth and level topography. However, the grinding and polishing process generates many fine particles and debris that are difficult to remove from the wafer surface. Such debris may contaminate a wafer and decrease device yield of the wafer.

Yet another method involves spin-on glass (SOG), photoresists, or other materials in interlevel dielectric planarization. Typically, the interlevel dielectric material is dispensed at the center of a wafer, and the wafer is spun about its center point to spread the material to its outer edges. The dielectric material and portions of the underlying oxide are then etched away. However, the results of the convention planarization process is often greatly dependent on interrelated factors such as the speeds at which the wafer is spun, the viscosity of the dielectric, how the material is dispensed, and various other factors. Furthermore, because of the uneven features in the wafer topography and the direction of the centrifugal force with respect to the wafer surface, excess dielectric material may accumulate around certain features on the side closest to the center of the wafer. The result is often a smooth but not planar surface. The conventional solution to this problem is chemical mechanical polish or lapping, where a grinding solution is used to polish the wafer surface. Again, this process creates many fine particles that are difficult to remove. Device yield is detrimentally impacted if the cleaning process does not completely remove all the debris produced by this process.

As the size of wafers increase, these conventional methods produce even more unsatisfactory results. Accordingly, there arises a need for apparatus and a method for interlevel dielectric planarization which effectively produce smooth and even wafer surfaces.

### SUMMARY OF THE INVENTION

In accordance with the present invention, apparatus and a method for interlevel dielectric planarization are provided which substantially eliminate or reduce disadvantages and problems associated with prior apparatus and methods.

In one aspect of the present invention, apparatus for planarizing wafer surface includes wafer holders arranged along the inner surface of a cylindrical wall. The wafers are secured by the wafer holders against the inner surface of the cylindrical wall, which can be spun about its center axis.

In another aspect of the present invention, the wafer planarization apparatus includes a centrifuge with a cylindrical wall. The wafers are arranged and secured along the inner surface of the cylindrical wall perpendicularly with respect to the radial lines emanating from a center axis of the cylindrical wall.

In yet another aspect of the present invention, a method for wafer planarization includes the step of applying a dielectric material to one surface of a wafer, and situating the wafer so that the side with the dielectric material faces a common center axis. The wafers are then spun about the center axis to create a centrifugal force directed perpendicularly toward the wafer surfaces facing the common center axis.

In yet another aspect of the invention, the planarization method includes applying a flowable dielectric to one surface of each wafer, and then applying a force of a predetermined value directed perpendicularly into the wafer surfaces.

An important technical advantage of the present invention is the simplicity of both the construction of the apparatus and the applicability of the method to planarize the wafer surfaces. A smooth and even wafer surface is achieved without mechanical grinding or polishing which can gravely impact the device yield of the fabrication process. The advantages of the instant invention will be more apparent as semiconductor designs incorporate multiple metal layers and connections, wafer slices increase in size, and circuit features become even more minute.

### BRIEF DESCRIPTION OF THE DRAWINGS

For a better understanding of the present invention, reference may be made to the accompanying drawings, in which:
FIG. 1 is a cross-sectional side view of apparatus for planarization in accordance with the present invention; and
FIG. 2 is a top view of the apparatus.

### DETAILED DESCRIPTION OF THE INVENTION

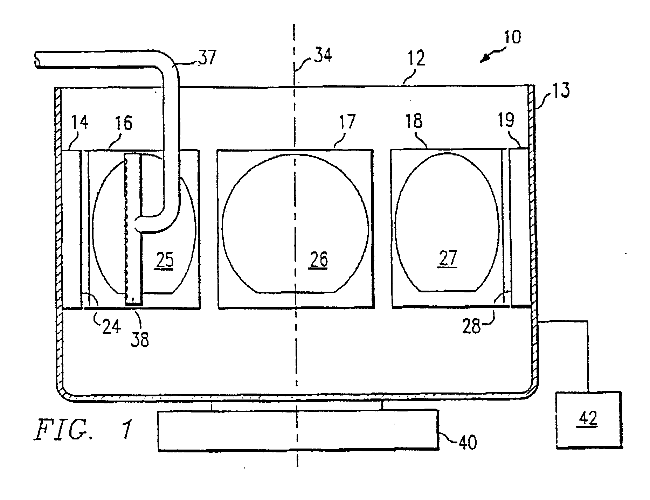

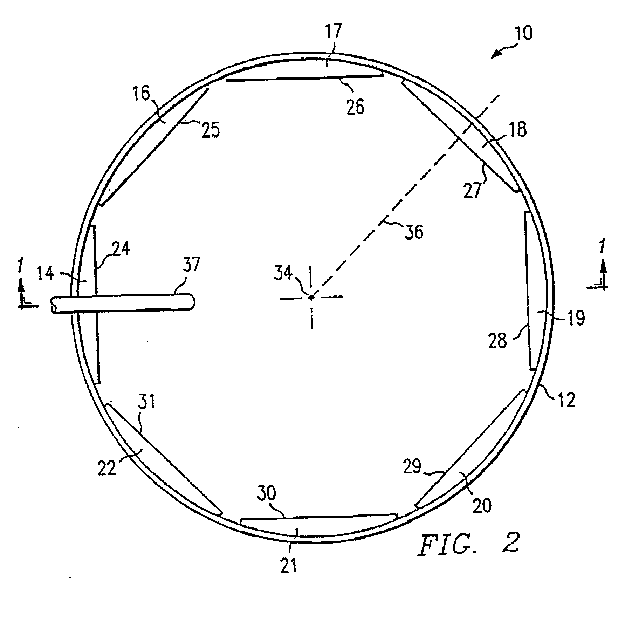

With reference to the drawings, FIGS. 1 and 2 illustrate a preferred embodiment of the apparatus for interlevel dielectric planarization, indicated generally at 10 and constructed according to the teaching of the present invention. Apparatus 10 includes a centrifuge having a tub 12 with a cylindrical vertical side wall 13. Arranged on the inner surface of cylindrical side wall 13 are wafer holders 14-22 or any suitable devices for securely fastening wafers 24-31 to the spinning cylindrical wall 13 of the centrifuge. Wafers 24-31 are positioned so that the sides being processed face the center axis 34 of cylindrical side wall 13. Furthermore, the wafers are positioned perpendicularly with respect to radial lines 36 emanating from center axis 34.

An optional spray apparatus 37 with an elongated spray bar 38 may be properly situated to apply a flowable or liquid dielectric material, such as spin-on glass, photoresist, or any other suitable interlevel dielectric material, onto the surfaces of wafers 24-31. Spin-on glass is a term commonly used to refer to siloxanes or silicates mixed in alcohol-based solvents. A motor or any other suitable driving mechanism 40 as known in the art is coupled to tub 12 for spinning it about its center axis 34. Ideally, the speed and duration of the spinning process is controllable and adjustable.

An optional feature of apparatus 10 may include a heating device 42 coupled to tub 12 which is capable of transferring heat to tub 12 and consequently wafers 24-31. The temperature of the heat transferred is preferably adjustable and controllable. Alternatively apparatus 10 may be housed in an enclosure, the temperature of which is controllable.

It can be seen from the foregoing and the discussion below that FIGS. 1 and 2 merely serve to illustrate the manner in which apparatus 10 may be constructed. For example, the number of wafers that can be processed simultaneously, the way the wafers are arranged about the centrifuge, and how they are secured in place may vary in actual practice. Among these variables is the constant that apparatus 10 is operated such that force, centrifugal or otherwise, is directed perpendicularly into the wafer surface for planarization thereof.

In operation wafers 24-31 may be manually coated individually by spraying a predetermined amount of flowable dielectric material onto their processing sides and then loaded into apparatus 10. The amount of dielectric material is dependent on the size of the wafer slices, its surface topography, and the speeds at which the centrifuge operates. Alternatively wafers 24-31 may be loaded into holders 14-22 of apparatus 10 with their processing sides facing center axis 34. Driver mechanism 40 is switched on to slowly rotate side wall 13 about center axis 34, and the dielectric material is sprayed onto wafers 24-31 successively by operating spray apparatus 37 as each wafer passes before it.

After wafers 24-31 are coated with the dielectric material and loaded into holders 14-22, driver mechanism 40 is switched on to cause tub 12 to spin at a predetermined acceleration rate and to reach a predetermined speed. At the same time, heater 42 delivers heat to wafers 24-31 causing their temperatures to rise in a controlled manner. The rise in temperature on the wafer surfaces causes the dielectric material thereon to be even more flowable. The temperature is controlled in such a manner that the dielectric material will not drain off the wafers when spinning stops. The spinning generates a centripetal force directed toward center axis 34, and a corresponding centrifugal force away from center axis 34 and perpendicularly into the wafer surfaces. The centrifugal force compresses the flowable dielectric material into the wafer surfaces and causes it to spread. In this manner, the dielectric material flows and forms an even and planar surface on the wafers. Subsequent fabrication steps may be carried out to complete wafer processing. The instant apparatus and method may be advantageously employed several times during the wafer fabrication process, such as between metal layers, to planarize the wafer surface as needed in preparation of constructing the upper layers.

Although the present invention has been described in detail, it should be understood that various changes, substitutions and alterations can be made thereto without departing from the spirit and scope of the present invention as defined by the appended claims.

## Claims

1. Wafer planarisation apparatus, comprising:
a cylindrical wall having an inner surface;
a wafer holder coupled to the inner surface of the cylindrical wall, the wafer holder adapted for holding a wafer against said inner surface of said cylindrical wall.

2. The apparatus, as set forth in claim 1, wherein the wafer holder holds the wafer perpendicular to radial lines emanating from the central axis of said cylindrical wall.

3. The apparatus, as set forth in claim 1 or claim 2 further comprising a driver coupled to said cylindrical wall for spinning said cylindrical wall around its central axis and wherein said driver spins said cylindrical wall at a predetermined speed.

4. The apparatus as set forth in any preceding claim wherein the cylindrical wall forms part of a centrifuge.

5. The apparatus, as set forth in any preceding claim, further comprising a spray bar for applying a liquid evenly across the wafer.

6. The apparatus, as set forth in claim 5, wherein said liquid is a dielectric material.

7. The apparatus, as set forth in claim 5, wherein said liquid is spin-on glass.

8. The apparatus, as set forth in claim 5, wherein said liquid is a photoresist.

9. The apparatus, as set forth in any preceding claim, further comprising a heater for causing a rise in wafer surface temperature.

10. The apparatus, as set forth in any preceding claims, wherein there are a plurality of wafer holders coupled to the inner surface of the wall.

11. A method for wafer planarization, comprising the steps of:
applying a liquid to one surface of at least one wafer;
situating said wafer so that the surface having said liquid applied faces a central axis; and
spinning said wafer about said central axis.

12. The method, as set forth in claim 11, wherein said spinning step continues until said liquid coats said wafer surface evenly.

13. The method, as set forth in claim 11 or claim 12, wherein said liquid applying step includes spraying said liquid onto said wafer surface.

14. The method, as set forth in any of claims 11 to 13, wherein said liquid applying step includes spraying a liquid selected from the group containing a dielectric liquid; spin-on glass or photoresist.

15. The method, as set forth in any of claims 11 to 14, further comprising the step of heating said wafers.
